# EUROPEAN PATENT APPLICATION

(11) **EP 4 303 250 A1**
(43) Date of publication of application: **10.01.2024**
(21) Application number: 22762777.5
(22) Date of filing: 12.01.2022
(51) Int. Cl.: C08G 73/10, C08L 79/08, H01L 21/56, H01L 23/29, H01L 23/31

(54) **POLY(AMIDE-IMIDE) RESIN, RESIN COMPOSITION, AND SEMICONDUCTOR DEVICE**

(30) Priority: 04.03.2021 JP 2021034526
(71) Applicant: Resonac Corporation, Tokyo 105-8518 (JP)
(72) Inventor: HASHIMOTO Gaku, Minato-ku, Tokyo 105-8518 (JP); NIWA Takaaki, Minato-ku, Tokyo 105-8518 (JP); SATO Eiichi, Minato-ku, Tokyo 105-8518 (JP); SATO Mizuki, Minato-ku, Tokyo 105-8518 (JP)
(74) Representative: Hoffmann Eitle
(86) International application number: PCT/JP2022/000703
(87) International publication number: WO 2022/185718

(57) **Abstract**

A polyamideimide resin containing a structural unit (Ia) represented by a formula below, and at least one selected from the group consisting of structural units (IIa), (IIb), and (IIc) represented by a formula below. In the structural unit (Ia), each X independently represents a hydrogen atom or a substituent selected from the group consisting of a halogen atom, an alkyl group of 1 to 9 carbon atoms, an alkoxy group of 1 to 9 carbon atoms, and a hydroxyalkyl group. In the structural units (IIa), (IIb), and (IIc), each S independently represents an alkyl group of 1 to 3 carbon atoms, a represents an integer of 0 to 4, b represents an integer of 0 to 3, and c represents an integer of 0 to 4.

## Description

### TECHNICAL FIELD

One embodiment of the present invention relates to a polyamideimide resin containing a cardo structure fluorene skeleton. Further, other embodiments of the present invention relate to a resin composition containing the polyamideimide resin, and a semiconductor device that uses the resin composition.

### BACKGROUND ART

The carbon dioxide (CO₂) discharged from all manner of industrial equipment and the like is one of the main causes of global warming. Accordingly, the building of a low-carbon society is required to address the problem of global warming. An example of one method of realizing a low-carbon society involves using power semiconductors in industrial equipment to reduce power loss. Power semiconductors are also applied to a variety of applications such as automobiles, and demand therefor is increasing. Examples of power semiconductors for automobiles include power cards, and TO, SOP, QFP, BGA and CSP packages.

In recent years, particularly as a result of the electrification of vehicles (EV), the power density of power semiconductors has increased, and the device drive temperature (Tj) has also risen. As a result, the temperature requirement during heat cycle testing has also increased.

However, conventional power semiconductors can sometimes suffer from detachment between component members, such as at the interface between the resin sealing layer and the substrate or semiconductor element, in heat cycle testing that assumes a higher drive temperature (increased Tj value). Because detachment between the members in a semiconductor device can lead to device failure, the reliability of the semiconductor device declines markedly.

Various investigations are currently being conducted from the viewpoint of the resin sealing material making up the resin sealing layer, in order to contend with the increased Tj values of power semiconductor devices. For example, the development of resin sealing materials with excellent heat resistance is underway, and in the case of a resin sealing material with a glass transition temperature exceeding 230°C, excellent heat resistance is exhibited even in a high-temperature region exceeding 200°C. However, on the other hand, because the resin becomes harder, adhesion with members tends to deteriorate and the reliability of the power semiconductor device tends to decline. In addition, detachment between members may occur in the reflow step during device mounting.

Accordingly, from the viewpoint of improving the reliability of semiconductor devices, a method that enhances the adhesion between members in a semiconductor device in order to suppress detachment between the members in high-temperature heat cycle testing and the reflow step is desirable.

In this regard, there is a known method in which a primer layer using a resin material is formed between the members of a semiconductor device to improve the adhesion between the members and thereby prevent detachment. For example, a method has been investigated in which a primer layer using a polyamideimide resin is provided between a metal lead frame and a sealing material to suppress the occurrence of detachment (Patent Document 1).

### PRIOR ART DOCUMENTS

### PATENT DOCUMENTS

Patent Document 1: JP 2013-135061 A

### SUMMARY OF THE INVENTION

### PROBLEMS TO BE SOLVED BY THE INVENTION

However, due to the increased Tj values of power semiconductor devices, the conditions required in semiconductor device reliability testing become more stringent, and adequately satisfying the required conditions with conventional resin materials is becoming difficult. Consequently, from the viewpoint of providing power semiconductors of high reliability, the development of resin materials with excellent heat resistance, which can prevent detachment between members even in a high-temperature region exceeding 250°C, for example, has become increasingly desirable.

Accordingly, in light of the circumstances described above, the present invention provides a resin material that exhibits excellent heat resistance, is capable of improving the adhesion between members to suppress the occurrence of detachment, and in particular, can be used favorably as a primer layer-forming material that is provided between members of a semiconductor device.

### MEANS TO SOLVE THE PROBLEMS

From the viewpoint of ameliorating detachment between members in heat cycle testing in a high-temperature region, the resin material used in forming the primer layer preferably has a glass transition temperature (Tg) that is higher than the upper limit for the drive temperature (Tj) of the power semiconductor. In general, it is known that a resin softens at temperatures exceeding the Tg of the resin and the adhesion deteriorates. Therefore, when the Tg of the resin is lower than the drive temperature of the power semiconductor, heat resistance becomes insufficient and it becomes difficult to ensure adhesion between members. As a result, for example, detachment occurs between the resin sealing layer and the substrate or semiconductor element.

As a result of intensive investigations relating to polyamideimide resins and resin compositions thereof as resin materials, the inventors of the present invention discovered that a polyamideimide resin having a cardo structure fluorene skeleton has a high Tg value. Further, they also discovered that, for example, when a primer layer is formed between various members, such as between the resin sealing layer and the substrate or semiconductor element, using a polyamideimide resin having the above specific structural unit, or a resin composition that contains such a resin, excellent adhesion between the members can be obtained, enabling them to complete the present invention.

In other words, embodiments of the present invention relate to the following aspects. However, the present invention is not limited to the embodiments described hereinafter, and it is possible for various modifications to be added.

One embodiment relates to a polyamideimide resin containing a structural unit (Ia) represented by the formula below, and at least one selected from the group consisting of structural units (IIa), (IIb), and (IIc) represented by the formulas below.

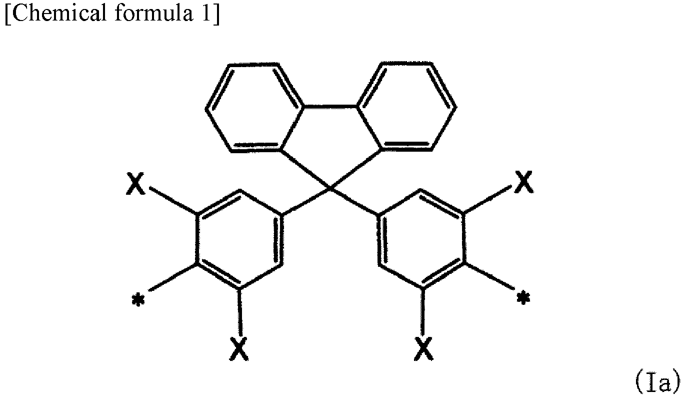

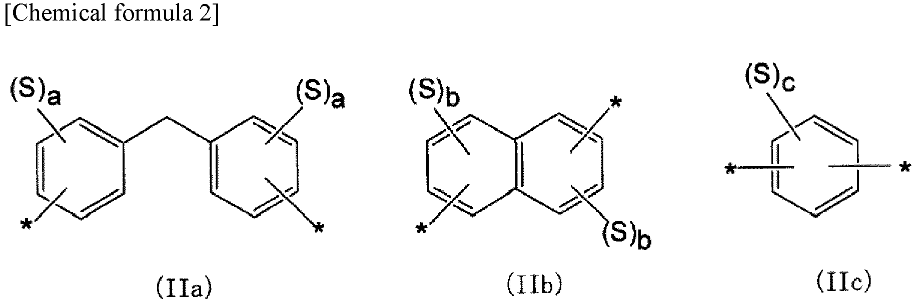

In the above formula (Ia), each X independently represents a hydrogen atom or a substituent selected from the group consisting of a halogen atom, an alkyl group of 1 to 9 carbon atoms, an alkoxy group of 1 to 9 carbon atoms, and a hydroxyalkyl group.

In the above formulas (IIa), (IIb), and (IIc), each S independently represents an alkyl group of 1 to 3 carbon atoms, a represents an integer of 0 to 4, b represents an integer of 0 to 3, and c represents an integer of 0 to 4.

The polyamideimide resin preferably also contains a structural unit (IIIa) represented by the formula below.

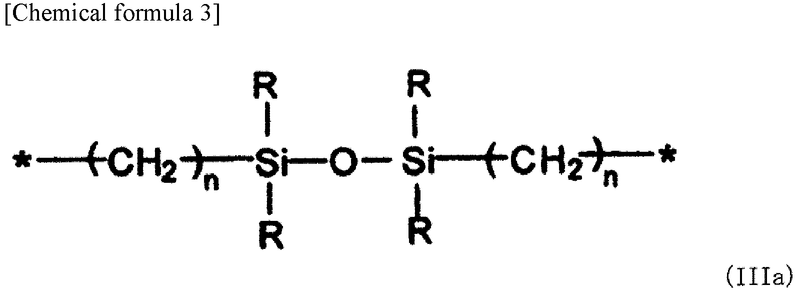

In the above formula (IIIa), each R independently represents a hydrogen atom or a substituent selected from the group consisting of an alkyl group of 1 to 9 carbon atoms, an alkoxy group of 1 to 9 carbon atoms, and a halogen atom, and n represents an integer of 1 to 6.

The polyamideimide resin preferably has a coefficient of linear expansion of 40 to 70 ppm/°C.

In the polyamideimide resin, the proportion of the structural unit (Ia) is preferably 20 mol% or more based on the total amount of the structural unit (Ia) and at least one selected from the group consisting of the structural units (IIa), (IIb), and (IIc).

The polyamideimide resin preferably has a glass transition temperature of 250°C or higher. The polyamideimide resin more preferably has a glass transition temperature of 300°C or higher.

Another embodiment relates to a polyamideimide resin composition containing the polyamideimide resin of the above embodiment and a solvent. The polyamideimide resin composition preferably also contains a coupling agent.

Another embodiment relates to a semiconductor device including a substrate and a film formed using the polyamideimide resin composition of the above embodiment. The semiconductor device preferably also has a resin sealing layer.

The disclosure of the present application is related to the subject matter disclosed in Japanese Patent Application No. 2021-34526 filed on March 4, 2021, the disclosed contents of which are incorporated herein by reference.

### EFFECTS OF THE INVENTION

The present invention is able to provide a resin material that exhibits excellent heat resistance, is capable of improving the adhesion between members and suppressing the occurrence of detachment at high temperatures, and can be used favorably as a primer layer-forming material that is provided between members in a semiconductor device.

### BRIEF DESCRIPTION OF THE DRAWINGS

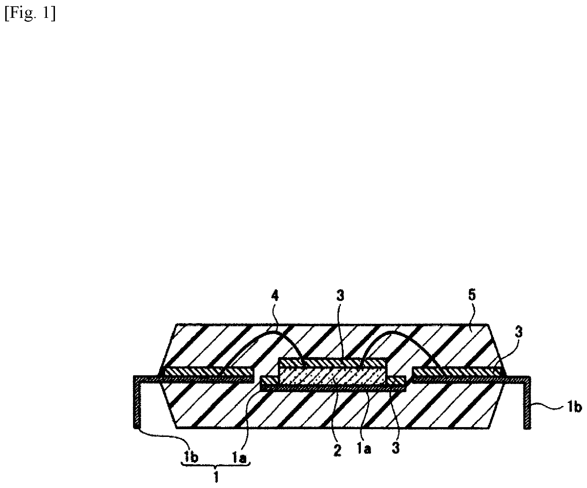

[Fig. 1] Fig. 1 is a schematic cross-sectional view illustrating one example of a semiconductor device that represents one embodiment.

### EMBODIMENTS FOR CARRYING OUT THE INVENTION

Preferred embodiments of the present invention are described below in further detail. However, the present invention is not limited to the following embodiments.

### <Polyamideimide Resin>

In one embodiment, a polyamideimide resin contains a structural unit (Ia), and at least one selected from the group consisting of structural units (IIa), (IIb), and (IIc), described below. The details of the structural units are as follows.

Structural unit (Ia) is represented by the formula below.

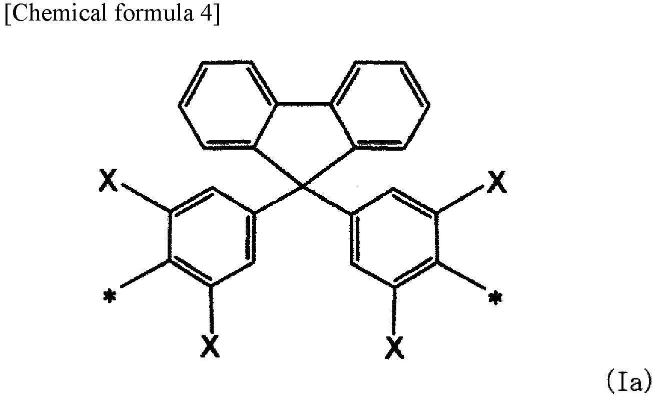

In the structural unit (Ia), each X may be the same or different from each other. Each X independently represents a hydrogen atom or a substituent selected from the group consisting of a halogen atom, an alkyl group of 1 to 9 carbon atoms, an alkoxy group of 1 to 9 carbon atoms, and a hydroxyalkyl group. The halogen atom may be a fluorine atom, a chlorine atom, or a bromine atom. The alkyl group and the alkoxy group may have any of a linear structure, a branched structure, and a cyclic structure.

In one embodiment, each X is preferably a hydrogen atom, an alkyl group of 1 to 9 carbon atoms, or a halogen atom. The alkyl group is more preferably an alkyl group of 1 to 6 carbon atoms, and even more preferably an alkyl group of 1 to 3 carbon atoms. In one embodiment, each X is preferably a hydrogen atom.

Structural units (IIa), (IIb), and (IIc) are represented by the formulas below.

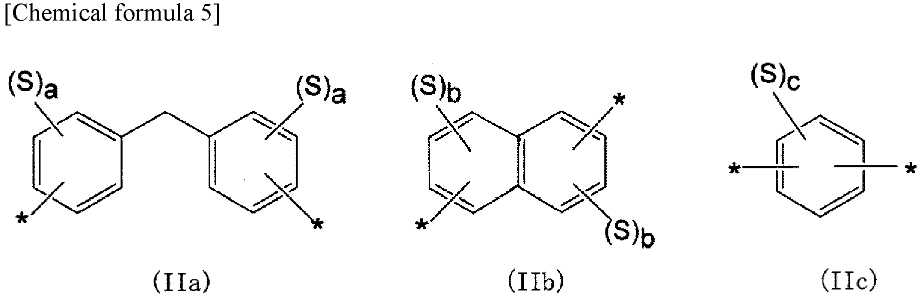

In the above structural units (IIa), (IIb), and (IIc), each S independently represents an alkyl group of 1 to 3 carbon atoms, a represents an integer of 0 to 4, b represents an integer of 0 to 3, and c represents an integer of 0 to 4.

The alkyl group may have any of a linear structure and a branched structure, but preferably has a linear structure. The number of carbon atoms of the alkyl group is more preferably 1 or 2. When the alkyl group has a linear structure, particularly when it is an alkyl group of 1 or 2 carbon atoms, it tends to be easy to obtain a resin with a rigid structure. By forming a film using a resin with a rigid structure, it tends to be easy to keep the coefficient of linear expansion (CTE) low. By keeping the CTE of the film low, it becomes easy to keep the CTE difference with other members small in an environment where the film is used in a semiconductor device, for example. As a result, in a semiconductor device for example, the stress generated by heat can be reduced, and the reliability of the semiconductor device tends to be easily improved.

In one embodiment, the structural units (IIa), (IIb), or (IIc) can be derived using a diamine compound or a diisocyanate compound having a structure corresponding thereto. Specific examples of diamine compounds with which the structural units (IIa), (IIb), and (IIc) can be derived include, but are not particularly limited to, the following. The amino groups shown in the compounds below may be substituted with isocyanate groups.

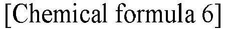

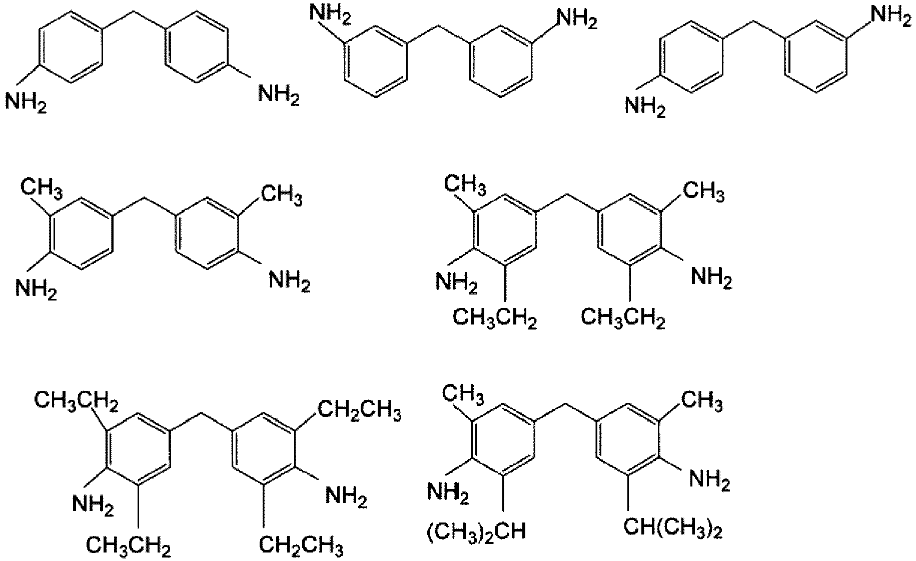

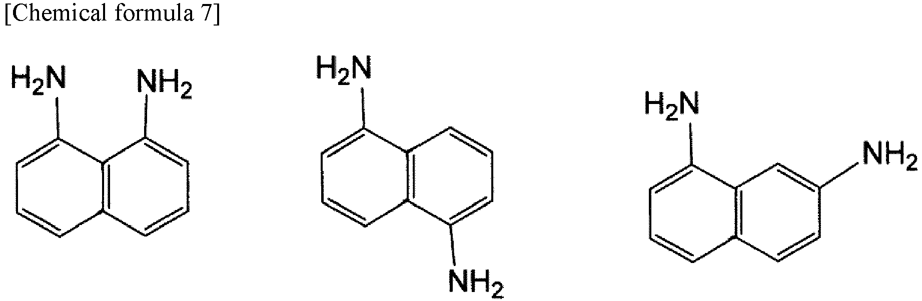

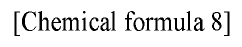

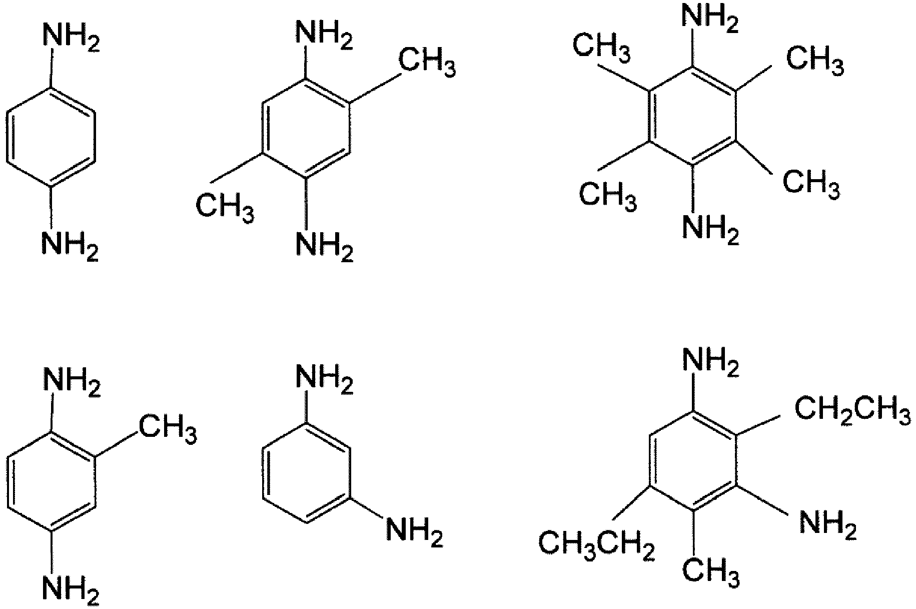

In one embodiment, a in the structural unit (IIa) is preferably 0 to 3, more preferably 0 to 2, even more preferably 0 or 1, and most preferably 0, b in the structural unit (IIb) is preferably 0 to 2, more preferably 0 or 1, and most preferably 0, and c in the structural unit (IIc) is preferably 0 to 3, more preferably 0 to 2, even more preferably 0 or 1, and most preferably 0.

When the number of substituents in the structural unit (IIa), (IIb), or (IIc) is lower, particularly when it is unsubstituted (in other words, if a, b, or c is 0), it tends to be easy to obtain a resin with a rigid structure. By forming a film using a resin with a rigid structure, it tends to be easy to keep the coefficient of linear expansion (CTE) low. By keeping the CTE of the film low, it becomes easy to keep the CTE difference with other members small in an environment where the film is used in a semiconductor device, for example. As a result, in a semiconductor device for example, the stress generated by heat can be reduced, and the reliability of the semiconductor device tends to be easily improved.

From the viewpoints described above, in one embodiment, the polyamideimide resin preferably contains the structural unit (Ia) and at least one selected from the group consisting of the structural units (IIa-1), (IIb-1), and (IIc-1) represented by the formulas below. Although not particularly limited, it is more preferable that two linkage sites (represented by "*") with other structural sites have a para-position relationship with each other.

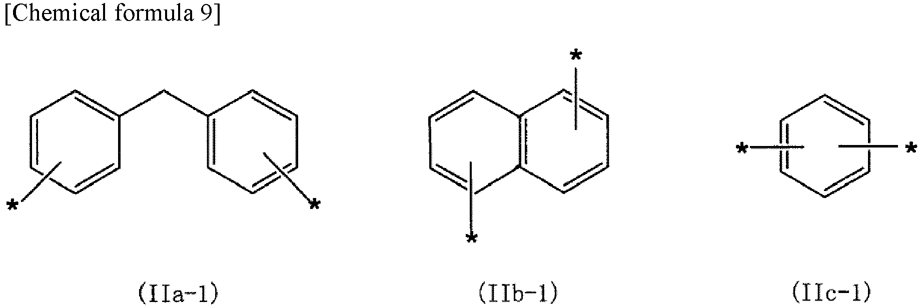

A polyamideimide resin is a resin having amide linkages and imide linkages within the molecular skeleton, and for example, can be obtained by a reaction between a diamine component or diisocyanate component and an acid component such as a tricarboxylic acid anhydride. From this type of viewpoint, in one embodiment, a polyamideimide resin containing the structural unit (Ia) and at least one of the structural units (IIa), (IIb), and (IIc) can be derived using a compound represented by formula (I) below and at least one compound represented by formulas (IIA), (IIB), and (IIC) below. The structural unit (Ia) and the structural units (IIa), (IIb), and (IIc) correspond with residues obtained upon elimination of a substituent Y (amino group or isocyanate group) from the compounds represented by formula (I) below and formulas (IIA), (IIB), and (IIC) below, and may be bonded directly to an amide linkage site or an imide linkage site in the structure of the resin.

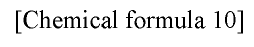

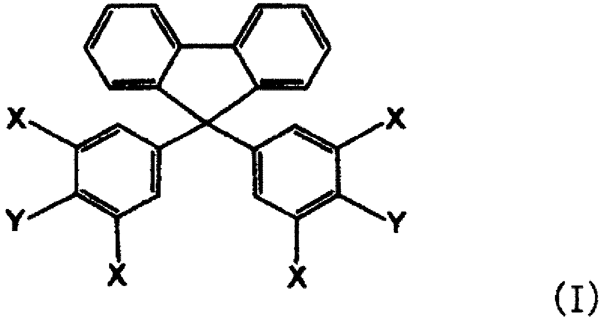

In the formula (I), Y is an amino group (-NH₂) or an isocyanate group (-NCO). Furthermore, X is as previously described in the item of (Ia).

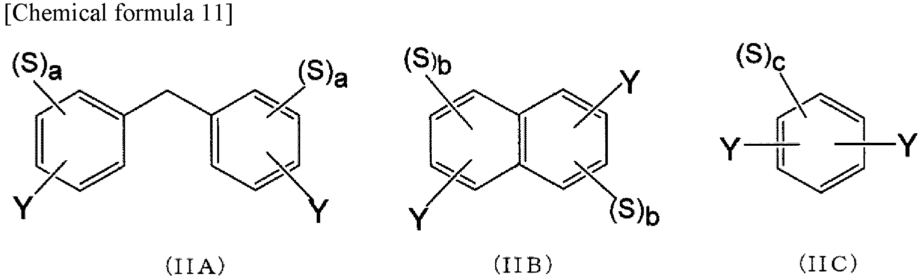

In the formulas (IIA), (IIB), and (IIC), Y is an amino group (-NH₂) or an isocyanate group (-NCO). Furthermore, S, a, b, and c are as previously described.

Specific examples of the compound represented by the formula (I) include 9,9-bis(4-aminophenyl)fluorene, 9,9-bis(4-amino-3-methylphenyl)fluorene, 9,9-bis(4-amino-3-chlorophenyl)fluorene, and 9,9-bis(4-amino-3-fluorophenyl)fluorene. These can be used favorably as diamine compounds with which the structural unit (Ia) can be derived.

Specific examples of the compound represented by the formula (IIA) include 4,4'-diaminodiphenylmethane, 3,4'-diaminodiphenylmethane, and 3,3'-diaminodiphenylmethane. These can be used favorably as diamine compounds with which the structural unit (IIa-1) can be derived.

Specific examples of the compound represented by the formula (IIB) include 1,5-naphthalenediamine and 1,8-naphthalenediamine. These can be used favorably as diamine compounds with which the structural unit (IIb-1) can be derived.

Specific examples of the compound represented by the formula (IIC) include 1,3-phenylenediamine and 1,4-phenylenediamine. These can be used favorably as diamine compounds with which the structural unit (IIc-1) can be derived.

From the viewpoint of suppressing detachment between members at the drive temperature (Tj) or reflow temperature of the power semiconductor, for example, the polyamideimide resin preferably has a glass transition temperature that is higher than the upper limit for the Tj or the reflow temperature. In this description, the "glass transition temperature (Tg)" is a value obtained using a film obtained by applying and then heating and drying a resin that has been dissolved in a solvent, and using a thermomechanical analyzer.

In one embodiment, a heat cycle test assuming a higher drive temperature (increased Tj value) of a power semiconductor is performed at a temperature of 175°C or higher. Furthermore, when the semiconductor is mounted and when reflow processing is performed, a heat cycle test is performed at a high temperature of approximately 260°C. Accordingly, in one embodiment the Tg of the polyamideimide resin is preferably 250°C or higher. The Tg of the polyamideimide resin is more preferably 270°C or higher, even more preferably 290°C or higher, and even still more preferably 300°C or higher.

Detachment between members in the reflow step when the device is mounted occurs when the stress generated due to rapid vaporization of moisture contained in the device and the stress caused by a difference in linear expansion between members exceed the adhesive strength between members. In one embodiment, from the viewpoint of suppressing detachment in the reflow step, the Tg of the polyamideimide resin is preferably 300°C or higher, and more preferably 320°C or higher.

By using the polyamideimide resin of the above embodiment, a Tg of 250°C or higher can be easily obtained. In the polyamideimide resin of the above embodiment, it is thought that the structural unit (Ia) having a skeleton known as a cardo structure contributes to an increase in the Tg. In addition, it is surmised that the presence of the structural units (IIa), (IIb), and (IIc) in the resin enables a further increase in the Tg. Furthermore, when a film is formed using the polyamideimide resin, it tends to be possible to easily adjust the physical properties of the film such as the CTE, elastic modulus, or adhesion to an adherend of the film. For example, by adjusting the blend ratio of the structural unit (Ia) to the structural units (IIa), (IIb), and (IIc), it is possible to easily obtain the desired physical property values of the film such as the Tg, CTE, elastic modulus, and adhesion. As a result, when the polyamideimide resin of the above embodiment is used as a constituent material of a semiconductor device, it becomes easy to improve the reliability of the semiconductor device.

Generally, the flexibility of a film formed from a resin having a high Tg tends to decrease. When the flexibility of the film is low, the stress generated in the semiconductor device cannot be relieved, and detachment is likely. From this type of viewpoint, in one embodiment, the polyamideimide resin preferably contains the structural unit (IIIa) represented by the formula below. When the polyamideimide resin in the above embodiment further contains the structural unit (IIIa), it is thought that flexibility is improved and it is possible to easily obtain a film having excellent flexibility.

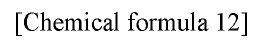

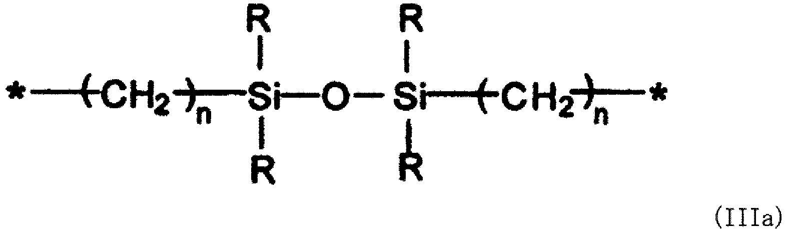

In the structural unit (IIIa), each R independently represents a hydrogen atom or a substituent selected from the group consisting of an alkyl group of 1 to 9 carbon atoms, an alkoxy group of 1 to 9 carbon atoms, and a halogen atom. The halogen atom may be a fluorine atom, a chlorine atom, or a bromine atom. The alkyl group and the alkoxy group may have any of a linear structure, a branched structure, and a cyclic structure.

In one embodiment, each R independently represents preferably an alkyl group of 1 to 9 carbon atoms, more preferably an alkyl group of 1 to 6 carbon atoms, and even more preferably an alkyl group of 1 to 3 carbon atoms.
n represents an integer of 1 to 6. n is preferably an integer of 2 to 4, and is more preferably 3 or 4.

In one embodiment, the structural unit (IIIa) can be derived using a compound represented by formula (III) below. The structural unit (IIIa) corresponds with a residue obtained upon elimination of a substituent Y (amino group or isocyanate group) from the compound represented by the formula (III) below, and may be bonded directly to an amide linkage site or an imide linkage site in the structure of the resin.

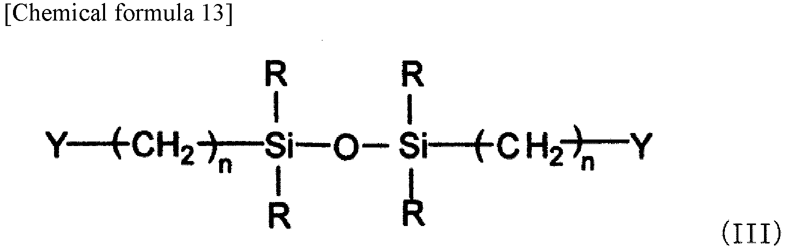

In the formula (III) above, Y is an amino group (-NH₂) or an isocyanate group (-NCO), and R and n are as previously described.

Specific examples of the compound represented by the formula (II) above include 1,3-bis(3-aminopropyl)-1,1,3,3-tetramethyldisiloxane, 1,3-bis(2-aminoethyl)-1,1,3,3-tetramethyldisiloxane, 1,3-bis(aminomethyl)-1,1,3,3-tetramethyldisiloxane, 1,3-bis(4-aminobutyl)-1,1,3,3-tetramethyldisiloxane, 1,3-bis(5-aminopentyl)-1,1,3,3-tetramethyldisiloxane, and 1,3-bis(6-aminohexyl)-1,1,3,3-tetramethyldisiloxane.

As described above, it is thought that the polyamideimide resin of the above embodiment having the combination of the structural unit (Ia) and at least one selected from the group consisting of structural units (IIa), (IIb), and (IIc), as well as having the structural unit (IIIa), makes it easy to achieve both a high glass transition temperature (Tg) and flexibility of the resin. Therefore, for example, when a primer layer provided between each member of a semiconductor device contains the polyamideimide resin of the above embodiment, excellent adhesion can be easily obtained even in tests carried out in a high-temperature region of 250°C or higher.

Furthermore, when a constituent material of a power semiconductor device contains the polyamideimide resin of the above embodiment, it becomes possible to suppress a decrease in adhesion resulting from the resin softening due to heat generated when the device is driven. Accordingly, with the polyamideimide resin of the above embodiment, it becomes possible to obtain high reliability in a power semiconductor device.

In a polyamideimide resin, the proportion of the structural unit (Ia) relative to the total amount of structural units derived from a diamine component and/or diisocyanate component may be 10 mol% or more, 15 mol% or more, 18 mol% or more, 30 mol% or more, 40 mol% or more, 45 mol% or more, 55 mol% or more, 65 mol% or more, or 70 mol% or more. The proportion of the structural unit (Ia) may be 95 mol% or less, 90 mol% or less, 85 mol% or less, 80 mol% or less, or 75 mol% or less.

In one embodiment, the proportion of the structural unit (Ia) may be 10 to 95 mol%, preferably 15 to 95 mol%, more preferably 45 to 90 mol%, even more preferably 55 to 85 mol%, and still even more preferably 65 to 80 mol%.

In one embodiment, as structural units derived from a diamine component and/or diisocyanate component, the total amount of the proportion of the structural unit (Ia) and the proportion of at least one of the structural units (IIa), (IIb), and (IIc) may be 70 mol% or more, 80 mol% or more, 85 mol% or more, 90 mol% or more, or 100 mol%. In one embodiment, the total amount may be 95 mol% or less.

In one embodiment, the proportion of the structural unit (Ia) may be 20 mol% or more based on the total amount of the structural unit (Ia) and at least one selected from the group consisting of the structural units (IIa), (IIb), and (IIc). The above proportion of the structural unit (Ia) may preferably be 45 mol% or more, may more preferably be 50 mol% or more, may even more preferably be 80 mol% or more, and may still even more preferably be 85 mol% or more.

Meanwhile, the proportion of at least one of the structural units (IIa), (IIb), and (IIc) is preferably 10 mol% or more relative to the total amount of structural units derived from a diamine component and/or diisocyanate component. In one embodiment, the above proportion is preferably 10 to 80 mol%, more preferably 12 to 65 mol%, and even more preferably 15 to 50 mol%. Note that when the polyamideimide resin contains two or more of the structural units (IIa), (IIb), and (IIc), the above proportion means the total proportion thereof.

In the polyamideimide resin, based on the total amount of all structural units making up the resin, the total amount of the proportion of the structural unit (Ia) and the proportion at least one of (IIa), (IIb), and (IIc) is preferably 35 mol% or more, more preferably 40 mol% or more, and even more preferably 45 mol% or more. Here, the proportion of each structural unit (mol%) is calculated from the number of moles added of the monomer compound corresponding to each structural unit.

In another embodiment, the polyamideimide resin preferably also contains the structural unit (IIIa). In one embodiment, the proportion of the structural unit (IIIa) relative to the total amount of structural units derived from a diamine component and/or diisocyanate component may be 20 mol% or less, 15 mol% or less, or 10 mol% or less. The proportion of the structural unit (IIIa) may be 2.5 mol% or more, 5.0 mol% or more, or 7.5 mol% or more.

In the above embodiment, as structural units derived from a diamine component and/or diisocyanate component, the total amount of the proportion of the structural unit (Ia), the proportion of at least one of the structural units (IIa), (IIb), and (IIc), and the proportion of the structural unit (IIIa) may be 75 mol% or more, 80 mol% or more, 85 mol% or more, 90 mol% or more, 95 mol% or more, or 100 mol%.

In the above embodiment, the proportion of the structural unit (IIIa) is preferably 2.5 to 20 mol%, more preferably 5 to 15 mol%, and even more preferably 7.5 to 10 mol%. By adjusting the proportion of the structural unit (IIIa) to be in the above ranges, the characteristics brought about by the structural unit (Ia) and at least one of the structural units (IIa), (IIb), and (IIc) can be easily expressed.

In yet another embodiment, in addition to the structural unit (Ia), at least one selected from the group consisting of the structural units (IIa), (IIb), and (IIc), and the structural unit (IIIa) as necessary, the polyamideimide resin may further contain an additional structural unit other than these structural units.

The additional structural unit may be a structural unit derived from an aromatic diamine or aromatic diisocyanate, an aliphatic diamine or aliphatic diisocyanate, and an alicyclic diamine or alicyclic diisocyanate, having a different structure from the structural units (Ia), (IIa), (IIb), (IIc), and (IIIa). The proportion of this kind of additional structural unit, relative to the total amount of structural units derived from a diamine component and/or diisocyanate component, is preferably 20 mol% or less. The proportion of the additional structural unit is more preferably 10 mol% or less, and even more preferably 5 mol% or less.

Examples of an aromatic diamine (diisocyanate) from which the additional structural unit can be derived include:
2,7-diaminofluorene,
9,9-bis[4-(4-aminophenoxy)phenyl]-9H-fluorene,
2,2'-ditrifluoromethyl-4,4'-diaminobiphenyl,
4,4'-diaminodiphenylsulfone,
3,3 -diaminodiphenylsulfone,
4,4'-diamino-2,2'-biphenyldisulfonic acid,
3,4'-diaminodiphenyl ether,
bis[4-(4-aminophenoxy)phenyl] sulfone,
bis[4-(3 -aminophenoxy)phenyl] sulfone,
2,2-bis[4-(4-aminophenoxy)phenyl]propane,
1,4-bis(4-aminophenoxy)benzene,
1,3 -bis(3 -aminophenoxy)benzene,
2,2-bis(4-aminophenyl)hexafluoropropane,
1,4-phenylenediamine,
2-chloro-1,4-phenylenediamine,
1,3 -phenylenediamine,
4,4'-diaminobenzophenone,
3,3 -diaminobenzophenone,
3,4'-diaminodiphenylmethane,
4,4'-diaminobenzanilide,
3,6-diaminocarbazole,
4,4'-bis(4-aminophenoxy)biphenyl,
2-trifluoromethyl-1,4-diaminobenzene,
2,2-bis[4-(4-aminophenoxy)phenyl]hexafluoropropane,
2,2-bis(4-aminophenyl)hexafluoropropane,
2,2'-bis(trifluoromethyl)benzidine,
2,2'-ditrifluoromethyl-4,4'-diaminobiphenyl ether,
4-aminophenyl sulfide,
4,4'-diamino-3,3'-dimethylbiphenyl,
naphthalenediamine, and
naphthalene diisocyanate.

Examples of an aliphatic diamine (diisocyanate) from which the additional structural unit can be derived include:
1,4-cyclohexanediamine,
1,3 -cyclohexanediamine,
1,4-di(aminomethyl)cyclohexane,
1,3 -bis(aminomethyl)cyclohexane,
bis(aminomethyl)norbornane,
4,4'-methylene-bis(cyclohexylamine),
hexamethylenediamine, and
hexamethylene diisocyanate.

In one embodiment, when a diamine is used in the production of a polyamideimide resin, an anhydride of an aliphatic or aromatic tricarboxylic acid can be used. From the viewpoint of heat resistance, it is preferable to use an anhydride of an aromatic tricarboxylic acid. In one embodiment, for example, it is preferable to use an acid halide of trimellitic anhydride as the acid component. From thereamong, it is particularly preferable to use trimellitic anhydride chloride represented by formula (IV) below.

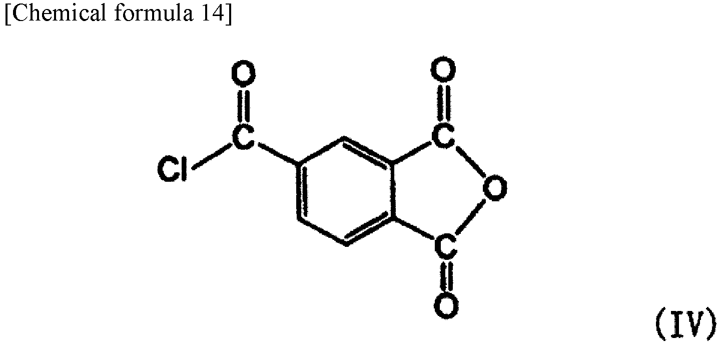

From the viewpoints described above, in one embodiment, the polyamideimide resin preferably contains a structural unit represented by formula (IVa) below, which can be derived from a reaction between an acid halide of trimellitic anhydride and a diamine component.

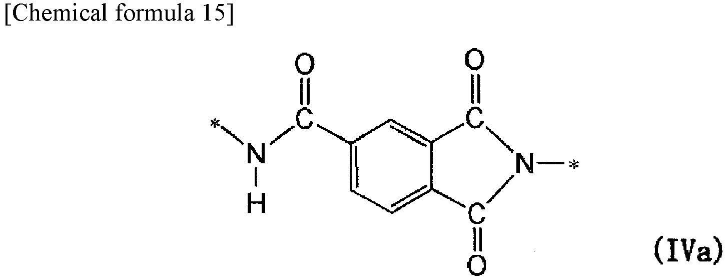

In one embodiment, based on the total amount of structural units derived from the acid component, the proportion of structural units derived from formula (IV) above is preferably 50 mol% or more, more preferably 75 mol% or more, and even more preferably 90 mol% or more. In other words, in one embodiment, based on the total amount of the acid component, the content of an acid halide of trimellitic anhydride is preferably 50% by mass or more, more preferably 75% by mass or more, and even more preferably 90% by mass or more.

In one embodiment, the proportion of structural units derived from formula (IV) above relative to the total amount of the acid component may be 100 mol%. In other words, in one embodiment, based on the total amount of the acid component, the content of an acid halide of trimellitic anhydride may be 100% by mass.

In one embodiment, the polyamideimide resin may be a resin obtained using a compound represented by formula (I) above and at least one compound selected from the group consisting of formulas (IIA), (IIB), and (IIC) above as the diamine component or diisocyanate component, and using a compound represented by formula (IV) above as the acid component. In another embodiment, the polyamideimide resin may be a resin obtained by also adding a compound represented by formula (III) above as a diamine component or diisocyanate component. In yet another embodiment, the polyamideimide resin may be a resin obtained by also using another acid component in addition to the compound represented by the formula (IV) above as the acid component.

Examples of acid components that may be used include tricarboxylic acid anhydrides or acid halides thereof other than a compound represented by formula (IV) above, and tricarboxylic acids such as trimellitic acid. Further, other compounds including tetracarboxylic dianhydrides such as pyromellitic anhydride and biphenyltetracarboxylic dianhydride, aromatic dicarboxylic acids such as terephthalic acid and isophthalic acid, alicyclic dicarboxylic acids such as cyclohexanedicarboxylic acid, and aliphatic dicarboxylic acids such as adipic acid and sebacic acid may also be used as the acid component.

The weight average molecular weight (Mw) of the polyamideimide resin is preferably within a range from 30,000 to 120,000. A polyamideimide resin having a Mw value within this range can readily form a coating film of a preferred thickness described below during the coating operation. The Mw value of the polyamideimide resin is more preferably within a range from 35,000 to 110,000, and even more preferably within a range from 38,000 to 100,000. In this description, "Mw" represents a value measured relative to standard polystyrenes using gel permeation chromatography.

From the viewpoints of workability and the like during film formation, the polyamideimide resin is preferably soluble in an organic solvent at room temperature. In this description, the expression "soluble in an organic solvent at room temperature" means that when a solution obtained by adding the organic solvent to the resin and stirring at room temperature is inspected visually, there is no sediment and no turbidity, with the entire solution having a transparent state. The above-mentioned "room temperature" may be within a range from about 10°C to 40°C, and is preferably within a range from 20°C to 30°C. In one embodiment, the above-mentioned "solution" means, for example, a solution obtained by adding 1 to 30 g of a powder of the above resin to 100 mL of the organic solvent. The organic solvent is described below.

### (Method for Producing Polyamideimide Resin)

The polyamideimide resin can be produced by publicly-known methods, and there are no particular limitations. For example, the polyamideimide resin can be produced via reaction between a diamine component and/or diisocyanate component, and an acid component. The diamine component, the diisocyanate component, and the acid component are as described above. The reaction may be performed in a solventless state or in the presence of an organic solvent. The reaction temperature is preferably within a range from 25°C to 250°C. The reaction time can be set as appropriate in accordance with factors such as the batch scale and the reaction conditions being employed.

There are no particular limitations on the organic solvent (reaction solvent) used during production of the polyamideimide resin. Examples of organic solvents that can be used include ether-based solvents such as diethylene glycol dimethyl ether, diethylene glycol diethyl ether, triethylene glycol dimethyl ether, and triethylene glycol diethyl ether; sulfur-containing solvents such as dimethylsulfoxide, diethylsulfoxide, dimethylsulfone, and sulfolane; cyclic ester-based (lactone-based) solvents such as γ-butyrolactone; acyclic ester-based solvents such as cellosolve acetate; ketone-based solvents such as cyclohexanone and methyl ethyl ketone; nitrogen-containing solvents such as N-methyl-2-pyrrolidone, dimethylacetamide, and 1,3-dimethyl-3,4,5,6-tetrahydro-2(1H)-pyrimidinone; and aromatic hydrocarbon-based solvents such as toluene and xylene. One of these organic solvents may be used alone, or a combination of two or more organic solvents may be used.

In one embodiment, an organic solvent that is capable of dissolving the produced resin is preferably selected and used, and the use of a polar solvent is preferred. Details regarding polar solvents are described below, but for example, nitrogen-containing solvents are preferred.

In one embodiment, the polyamideimide resin can be produced by a method in which a precursor to the polyamideimide resin is first produced by a reaction between the acid component and the diamine component, and this precursor is then subjected to dehydration cyclization to obtain the polyamideimide resin. However, there are no particular limitations on the precursor cyclization method, and a method that is well known in the technical field may be used. For example, a heat cyclization method in which the dehydration cyclization is achieved by conducting heating either at normal pressure or under reduced pressure, a chemical cyclization method that uses a dehydration agent such as acetic anhydride either in the presence of a catalyst or without a catalyst, or the like may be used.

In the case of a heat cyclization method, the cyclization is preferably performed while the water produced by the dehydration reaction is removed from the system. During the dehydration reaction, the reaction liquid may be heated to a temperature of 80°C to 400°C, and preferably 100°C to 250°C. Further, the water may also be removed by azeotropic distillation by using an organic solvent capable of forming an azeotrope with water, such as benzene, toluene, or xylene.

In the case of a chemical cyclization method, the reaction may be performed in the presence of a chemical dehydration agent, at a temperature of 0°C to 120°C, and preferably 10°C to 80°C. Examples of chemical dehydration agents that can be used favorably include acid anhydrides such as acetic anhydride, propionic anhydride, butyric anhydride, and benzoic anhydride, and carbodiimide compounds such as dicyclohexylcarbodiimide. During the reaction, a material that accelerates the cyclization reaction such as pyridine, isoquinoline, trimethylamine, triethylamine, aminopyridine, or imidazole is also preferably used in combination with the chemical dehydration agent.

The chemical dehydration agent may be used in a ratio of 90 to 600 mol% relative to the total amount of the diamine component, and the material that accelerates the cyclization reaction may be used in a ratio of 40 to 300 mol% relative to the total amount of the diamine component. Further, a dehydration catalyst, including phosphorus compounds such as triphenyl phosphite, tricyclohexyl phosphite, triphenyl phosphate, phosphoric acid and phosphorus pentoxide, and boron compounds such as boric acid and boric anhydride, may also be used.

In the production of the polyamideimide resin, the usage ratio (molar ratio) between the acid component and the diamine component (diisocyanate component) is not particularly limited, and can be adjusted to ensure that the reaction proceeds with neither excess nor deficiency. In one embodiment, from the viewpoints of the molecular weight and the degree of crosslinking of the produced polyamideimide resin, the total amount of the diamine component per 1.00 mol of the total acid component is preferably 0.90 to 1.10 mol, more preferably 0.95 to 1.05 mol, and even more preferably 0.97 to 1.03 mol.

### <Polyamideimide Resin Composition>

In one embodiment, a polyamideimide resin composition (hereafter sometimes abbreviated as a "resin composition") contains the polyamideimide resin of an embodiment described above, and a solvent. In this description, the resin composition is sometimes referred to as a varnish.

### (Solvent)

There are no particular limitations on the solvent, provided it is a solvent that is capable of dissolving the polyamideimide resin. The expression "solvent that is capable of dissolving the polyamideimide resin" means that when a solution is obtained by adding and mixing a powder of the polyamideimide resin with the solvent without any particular restriction of the temperature of the solvent, and the solution is then observed with the naked eye, no sedimentation or turbidity is visible and the entire solution has a transparent state. In one embodiment, the solvent that forms the resin composition may be the same solvent as the reaction solvent used during production of the resin. The use of a polar solvent is particularly preferred.

Examples of polar solvents include nitrogen-containing compounds such as N-methylpyrrolidone, dimethylacetamide, dimethylformamide and 1,3-dimethyltetrahydro-2(1H)-pyrimidinone; sulfur-containing compounds such as sulfolane and dimethylsulfoxide; lactones such as γ-butyrolactone, γ-valerolactone, γ-caprolactone, γ-heptalactone, α-acetyl-γ-butyrolactone and ε-caprolactone; ketones such as methyl ethyl ketone, methyl isobutyl ketone, cyclohexanone and acetophenone; acyclic esters such as cellosolve acetate; and ethers including ethylene glycol, glycerol, diethylene glycol dialkyl ethers such as diethylene glycol dimethyl ether, diethylene glycol diethyl ether, diethylene glycol dipropyl ether and diethylene glycol dibutyl ether, triethylene glycol dialkyl ethers such as triethylene glycol dimethyl ether, triethylene glycol diethyl ether, triethylene glycol dipropyl ether and triethylene glycol dibutyl ether, tetraethylene glycol dialkyl ethers such as tetraethylene glycol dimethyl ether, tetraethylene glycol diethyl ether, tetraethylene glycol dipropyl ether and tetraethylene glycol dibutyl ether, diethylene glycol monoalkyl ethers such as diethylene glycol monomethyl ether and diethylene glycol monoethyl ether, triethylene glycol monoalkyl ethers such as triethylene glycol monomethyl ether and triethylene glycol monoethyl ether, and tetraethylene glycol monoalkyl ethers such as tetraethylene glycol monomethyl ether and tetraethylene glycol monoethyl ether.

In one embodiment, the solvent is preferably at least one solvent selected from the group consisting of diethylene glycol dimethyl ether, triethylene glycol, triethylene glycol dimethyl ether, N-methyl-2-pyrrolidone, γ-butyrolactone, γ-valerolactone, δ-valerolactone, γ-caprolactone, ε-caprolactone, α-methyl-γ-butyrolactone, ethyl cellosolve, ethyl cellosolve acetate, butyl cellosolve, butyl cellosolve acetate, cyclopentanone, cyclohexanone, tetrahydrofuran, 1,4-dioxane, dibutyl ether, dimethylsulfoxide, 1,3-dimethyl-2-imidazolidinone, dimethylacetamide, N,N-dimethylformamide, ethylene carbonate, propylene carbonate, and propylene glycol methyl acetate. In those cases where a combination of two or more solvents is used, the solvents may be mixed in any arbitrary proportions.

Among the above solvents, from the viewpoint of film formability, a solvent with a comparatively low boiling point is preferred. For example, diethylene glycol dimethyl ether, triethylene glycol, triethylene glycol dimethyl ether, and the like can be used favorably.

The blend amount of the solvent in the above resin composition may be adjusted as appropriate with consideration being given to the viscosity. Although not a particular limitation, in one embodiment, the blend amount of the solvent is preferably a ratio of 500 to 3,500 parts by mass relative to 100 parts by weight of the total amount of resin in the resin composition. The solvent is more preferably added at a ratio of 5,000 to 2,000 parts by mass relative to 100 parts by mass of the total amount of resin.

### (Additives)

If required, additives such as colorants and coupling agents, and additional components such as resin modifiers may be added to the above polyamideimide resin composition (varnish). In those cases where the polyamideimide resin composition contains additional components, the blend amount of those additional components is preferably not more than 50 parts by mass relative to 100 parts by mass of the total amount of polyamideimide resin (solid fraction component) in the polyamideimide resin composition. By ensuring that the blend amount of these additional components is not more than 50 parts by mass, deterioration in the physical properties of the obtained coating film can be easily suppressed.

In one embodiment, the polyamideimide resin composition may contain a coupling agent. Examples of additional components that can be used are given below.

### (Coupling Agents)

There are no particular limitations on the types of coupling agents that can be used, and any of silane-based, titanium-based, and aluminum-based coupling agents may be used, but silane-based coupling agents are the most preferred. There are no particular limitations on the silane-based coupling agents, and examples include vinyltrichlorosilane, vinyltris(β-methoxyethoxy)silane, vinyltriethoxysilane, vinyltrimethoxysilane, γ-methacryloxypropyltrimethoxysilane, γ-methacryloxypropylmethyldimethoxysilane, β-(3,4-epoxycyclohexyl)ethyltrimethoxysilane, γ-glycidoxypropyltrimethoxysilane, γ-glycidoxypropylmethyldimethoxysilane, γ-glycidoxypropylmethyldiethoxysilane, N-β-(aminoethyl)-γ-aminopropyltrimethoxysilane, N-β-(aminoethyl)-γ-aminopropylmethyldimethoxysilane, γ-aminopropyltriethoxysilane, N-phenyl-γ-aminopropyltrimethoxysilane, γ-mercaptopropyltrimethoxysilane, γ-mercaptopropyltriethoxysilane, 3-aminopropylmethyldiethoxysilane, 3-ureidopropyltriethoxysilane, 3-ureidopropyltrimethoxysilane, 3-aminopropyltrimethoxysilane, 3-aminopropyl-tris[2-(2-methoxyethoxy)ethoxy]silane, N-methyl-3-aminopropyltrimethoxysilane, triaminopropyltrimethoxysilane, 3-4,5-dihydroimidazol-1-yl-propyltrimethoxysilane, 3-methacryloxypropyltrimethoxysilane, 3-mercaptopropylmethyldimethoxysilane, 3-chloropropylmethyldimethoxysilane, 3-chloropropyldimethoxysilane, 3-cyanopropyltriethoxysilane, hexamethyldisilazane, N,O-bis(trimethylsilyl)acetamide, methyltrimethoxysilane, methyltriethoxysilane, ethyltrichlorosilane, n-propyltrimethoxysilane, isobutyltrimethoxysilane, amyltrichlorosilane, octyltriethoxysilane, phenyltrimethoxysilane, phenyltriethoxysilane, methyltri(methacryloyloxyethoxy)silane, methyltri(glycidyloxy)silane, N-β-(N-vinylbenzylaminoethyl)-γ-aminopropyltrimethoxysilane, octadecyldimethyl-[3-(trimethoxysilyl)propyl]ammonium chloride, γ-chloropropylmethyldichlorosilane, γ-chloropropylmethyldimethoxysilane, γ-chloropropylmethyldiethoxysilane, trimethylsilyl isocyanate, dimethylsilyl isocyanate, methylsilyl triisocyanate, vinylsilyl triisocyanate, phenylsilyl triisocyanate, tetraisocyanatosilane, and ethoxysilane isocyanate. One of these may be used alone, or a combination of two or more may be used.

There are no particular limitations on the titanium-based coupling agents, and examples include isopropyltrioctanoyl titanate, isopropyldimethacrylisostearoyl titanate, isopropyltridodecylbenzenesulfonyl titanate, isopropylisostearoyldiacryl titanate, isopropyltri(dioctyl phosphate) titanate, isopropyltricumylphenyl titanate, isopropyltris(dioctyl pyrophosphate) titanate, isopropyltris(n-aminoethyl) titanate, tetraisopropylbis(dioctyl phosphite) titanate, tetraoctylbis(ditridecyl phosphite) titanate, tetra(2,2-diallyloxymethyl-1-butyl)-bis(ditridecyl) phosphite titanate, dicumylphenyloxyacetate titanate, bis(dioctyl pyrophosphate)oxyacetate titanate, tetraisopropyl titanate, tetra-normal-butyl titanate, butyl titanate dimer, tetra(2-ethylhexyl) titanate, titanium acetylacetonate, polytitanium acetylacetonate, titanium octylene glycolate, ammonium titanium lactate salt, titanium lactate, titanium lactate ethyl ester, titanium triethanolaminate, polyhydroxytitanium stearate, tetramethyl orthotitanate, tetraethyl orthotitanate, tetrapropyl orthotitanate, tetraisobutyl orthotitanate, stearyl titanate, cresyl titanate monomer, cresyl titanate polymer, diisopropoxy-bis(2,4-pentadionate) titanium(IV), diisopropyl-bis-triethanolaminotitanate, octylene glycol titanate, tetra-n-butoxytitanium polymer, tri-n-butoxytitanium monostearate polymer, and tri-n-butoxytitanium monostearate. One of these may be used alone, or a combination of two or more may be used.

There are no particular limitations on the aluminum-based coupling agents, and examples include aluminum chelate compounds such as ethylacetoacetatoaluminum diisopropylate, aluminum tris(ethylacetoacetate), alkylacetoacetatoaluminum diisopropylate, aluminum monoacetylacetate bis(ethylacetoacetate), aluminum tris(acetylacetonate), aluminum monoisopropoxymonooleoxyethyl acetoacetate, aluminum di-n-butoxide monoethylacetoacetate, and aluminum diisopropoxide monoethylacetoacetate, and aluminum alcoholates such as aluminum isopropylate, mono-sec-butoxyaluminum diisopropylate, aluminum sec-butylate and aluminum ethylate. One of these may be used alone, or a combination of two or more may be used.

In one embodiment, the viscosity of the polyamideimide resin composition is preferably within a range from 10 to 400 mPa s, and more preferably within a range from 10 to 300 mPa s. Here, the viscosity is a value obtained by measuring a varnish prepared by dissolving in the solvent to achieve a non-volatile component (solid fraction component) of 1 to 20% by mass, using an E-type viscometer at conditions of 25°C and 10 rpm. When the viscosity measured at 10 rpm is at least 10 mPa·s, a satisfactory film thickness can be easily ensured during coating. Further, when the viscosity is not more than 400 mPa·s, a uniform film thickness can be easily ensured during coating. Accordingly, by adjusting the viscosity to a value within the above range, excellent printability can be easily achieved.

In one embodiment, from the viewpoint of achieving excellent coating properties, the viscosity preferably exceeds 50 mPa·s, and more preferably exceeds 100 mPa·s. If the viscosity is too low, the composition may sometimes wet-spread outside the desired region and make handling difficult.

Note that the above viscosity can be measured using a viscometer (RE type) manufactured by Toki Sangyo Co., Ltd., for example. During the measurement, the measurement temperature is set to 25°C ± 0.5°C, 1 mL to 1.5 mL of the resin composition (varnish) is then inserted in the viscometer, and the viscosity is recorded 10 minutes after commencing measurement.

In one embodiment, the film thickness obtained upon film formation using the resin composition is not particularly limited, and may be 0.5 to 50 µm. By ensuring that the film has a thickness within this range, satisfactory adhesion tends to be easily achieved. From this viewpoint, the film thickness is preferably within a range from 1 to 15 µm, and even more preferably within a range from 3 to 15 µm.

In one embodiment, the elastic modulus at 35°C of a film having a thickness of 10 µm obtained by applying and then heating and drying the resin composition (varnish) is preferably within a range from 0.5 to 8.0 GPa, more preferably within a range from 1.0 to 5.0 GPa, and even more preferably within a range from 2.0 to 4.5 GPa. The heating and drying for forming the film can, for example, be carried out under the conditions of heating at 50°C for 10 minutes and then drying at 260°C for 1 hour. The above elastic modulus is a value measured using a dynamic viscoelasticity measurement device. From the viewpoint of further enhancing the reliability of power semiconductor devices, the film preferably has an appropriate level of flexibility. Accordingly, in one embodiment, the elastic modulus of the film is even more preferably within a range from 3.0 to 4.5 GPa.

The elastic modulus can be measured, for example, using a dynamic viscoelasticity measurement device "Rheogel-E4000 model" manufactured by UBM Co., Ltd. The elastic modulus is a value obtained, for example, using a film obtained by applying and drying the resin composition (varnish) and conducting measurement under conditions including a measurement frequency of 10 MHz and a measurement temperature of 35°C.

The resin composition of an embodiment described above has excellent heat resistance and flexibility, and can therefore be used favorably as a constituent material of a semiconductor device. For example, the resin composition can be used for forming an insulating layer, adhesive layer, protective layer, or the like in a semiconductor device, and semiconductor devices having these layers exhibit excellent adhesion between the various members and superior reliability.

In one embodiment, the resin composition can be used favorably in a semiconductor device for forming a primer layer provided between the sealing material and the substrate, between the sealing material and the semiconductor element, or the like. The adhesion between the various members can be evaluated using the shear strength.

In one embodiment, the shear strength at 260°C between members having a primer layer formed from the above resin composition is preferably 11 MPa or greater, more preferably 15 MPa or greater, and even more preferably 17 MPa or greater. Provided the shear strength at 260°C is 11 MPa or greater, excellent adhesion can be easily achieved even when using the resin composition in a power semiconductor device.

In one embodiment, in a laminate having a primer layer formed from the resin composition and then a resin sealing layer provided in this order on a substrate, the shear strength at 260°C between the substrate and the resin sealing layer can be 11 MPa or greater. The laminate can be obtained by applying the resin composition (varnish) to the substrate and performing drying to form a film, and subsequently forming the resin sealing layer on top of the film.

Measurement of the shear strength can be conducted, for example, using a shear strength measurement device (the 4000-series manufactured by Nordson Advanced Technology Corporation). The measurement can be performed, for example, using a sample obtained by applying the resin composition to a Ni substrate and performing drying to form a film, and then molding a resin sealing layer of ø5 mm on top of the film using an epoxy-based sealing resin. The conditions during measurement typically may include a heat stage temperature of 260°C and a probe speed of 3 mm/min. It is also possible for the material for the substrate and the sealing material for forming the resin sealing layer to be altered as appropriate.

In the measurement, a Cu substrate may be used instead of the Ni substrate, or a substrate having Ag plating on a Cu substrate may be used.

When the resin composition is used as described above to form a primer layer provided between the sealing material and the substrate, between the sealing material and the semiconductor element, or the like in a semiconductor device, from the viewpoint of suppressing the generation of stress due to thermal expansion and contraction and improving adhesion, it is preferable that the difference in the coefficient of linear expansion (CTE) between each member and the film made of the resin composition be small. From a viewpoint such as this, in one embodiment, the coefficient of linear expansion (CTE) of the polyamideimide resin is preferably in the range from 40 to 90 ppm/°C, more preferably in the range from 50 to 70 ppm/°C, and even more preferably in the range from 55 to 65 ppm/°C. Furthermore, the CTE of the resin composition containing the polyamideimide resin is also preferably within the above ranges.

The CTE is a value obtained using a film obtained by applying and drying the resin or the varnish of the resin composition and conducting measurement. The measurement can be conducted, for example, using a thermomechanical analyzer (TMA, "SS7100" manufactured by Hitachi High-Tech Science Corporation). The measurement conditions can be a chuck separation of 10 mm, a load of 10 g, and a rate of temperature increase of 10°C/min. The CTE specified herein is a value calculated from the slope of a straight line joining the values at 70°C and 140°C.

### <Semiconductor Device>

One embodiment relates to a semiconductor device having a substrate and a dried film obtained using the resin composition of an embodiment described above. The constituent members of a semiconductor device generally include a semiconductor element mounted on the substrate and a sealing member (sealing layer). A semiconductor element is typically formed from a semiconductor chip (Si, SiC, GaN), Cu, Ni plating, Ag plating, Au plating, Au/Pd/Ni plating, solder, sintered silver, sintered copper, Al wiring, Au wiring, and inorganic materials such as a ceramic substrate (alumina, alumina-zirconia, aluminum nitride, and silicon nitride). Furthermore, the sealing layer is typically formed from an organic material such as a resin. In the following description, a sealing layer formed from a resin is referred to as a resin sealing layer.

In the semiconductor device described above, by forming a dried film using the resin composition of an embodiment described above as a primer layer between the constituent members, the adhesion between the constituent members can be easily enhanced. More specifically, for example, by forming a dried film of the resin composition between the resin sealing layer and the substrate, or between the resin sealing layer and the semiconductor element, adhesion can be ensured between the various members, and it becomes possible to prevent detachment during cycle testing. From this type of viewpoint, in one embodiment, the semiconductor device has a substrate, a semiconductor element mounted on top of the substrate, a primer layer provided on at least the semiconductor element mounting surface of the substrate, and a resin sealing layer provided on top of the primer layer, in which the primer layer is preferably composed of a dried film formed using the semiconductor device resin composition of an embodiment described above. The substrate may be a lead frame composed of a die pad for mounting the semiconductor element and leads, in which the electrode pads of the semiconductor element and the leads of the lead frame are connected electrically via wires.

In one embodiment, the resin composition described above can be used favorably as a constituent material of a power semiconductor device that uses an above-mentioned silicon carbide (SiC) substrate or gallium nitride (GaN) substrate. When a power semiconductor device is formed using the above resin composition, deterioration in the adhesion between the various members during heat cycle testing can be easily suppressed.

A representative structure of the semiconductor device of an embodiment described above is described below in detail with reference to the drawing. Fig. 1 is a schematic cross-sectional view illustrating an embodiment of the semiconductor device. The semiconductor device illustrated in Fig. 1 has a die pad 1a, a semiconductor element 2, a primer layer 3, leads 1b, wires 4, and a resin sealing layer 5, in which the primer layer 3 is formed from the resin composition of an embodiment described above. As illustrated in Fig. 1, by providing the primer layer 3 formed from the resin composition on the semiconductor element mounting surface (the surfaces of the leads 1b and the die pad 1a on which the semiconductor element 2 is mounted) of the substrate 1 that contacts the resin sealing layer 5, the adhesion between the various members can be enhanced with ease.

In one embodiment, a method for producing a semiconductor device has, at least, a step of forming a primer layer by applying the resin composition of an embodiment described above to the surface of a substrate on which a semiconductor element has been mounted and then performing drying, and a step of forming a resin sealing layer on top of the primer layer.

In this embodiment, the primer layer is formed using the resin composition of an embodiment described above. From the viewpoint of workability, as the resin component, a resin composition (varnish) containing a polyamideimide resin is preferably used. The primer layer can be obtained by applying the resin composition to a prescribed location and then drying the coating film.

There are no particular limitations on the materials for the lead frame composed of the die pad used for mounting the semiconductor element and the leads, and materials that are well known in the technical field can be selected. From the viewpoint of application to power semiconductor devices, the die pad material is preferably at least one material selected from the group consisting of Ni and Cu. Further, the at least one material selected from the group consisting of Ni and Cu may have Ag plating on the surface thereof. The lead material of the lead frame is preferably selected from the group consisting of Ni and Cu.

The material of the semiconductor element is not particularly limited, and for example, may be a silicon wafer, a silicon carbide wafer, or the like.

The resin sealing layer may be formed using a sealing material that is well known in the technical field. For example, the resin sealing material may be a liquid or solid epoxy-based resin composition. The resin sealing layer can be formed, for example, by transfer molding using the resin sealing material.

In another embodiment, the method for producing the semiconductor device has, for example: a step of applying the resin composition of an embodiment described above to a semiconductor substrate on which a plurality of wires of the same structure have been formed, and then performing drying to form a resin layer; and, if necessary, a step of forming rewiring on top of the resin layer to electrically connect to electrodes on the semiconductor substrate. Further, in addition to these steps, if necessary, the production method may also include a step of forming a protective layer (resin layer) on top of the rewiring or the resin layer using the resin composition of an embodiment described above. Moreover, in addition to the above steps, if necessary, the production method may also include a step of forming external electrode terminals on the above resin layer, and then, if necessary, a step of performing dicing.

There are no particular limitations on the coating method for the above resin layer (primer layer), but spin coating, spray coating, or dispensing coating is preferred. The method used for drying the resin layer may employ a method that is publicly known in the technical field. The resin composition of an embodiment described above is also excellent in terms of characteristics such as sputtering resistance, plating resistance, and alkali resistance, which are necessary in the step of forming the rewiring. For these reasons, the resin composition of an embodiment described above is not limited to the configuration of a semiconductor device described above, and can be used favorably as a material in all manner of semiconductor devices.

### EXAMPLES

The present invention is described below in further detail by means of examples, but the present invention is not limited to these examples and includes all manner of embodiments.

### <1> Synthesis of Polyamideimide Resins

### (Synthesis Example 1)

A 1-liter four-neck flask fitted with a thermometer, a stirrer, a nitrogen inlet tube, and a condenser fitted with an oil-water separator was charged, under a stream of nitrogen, with 25.1 g of 9,9-bis(4-aminophenyl)fluorene, 3.6 g of 4,4'-diaminodiphenylmethane, and 2.5 g of 1,3-bis(3-aminopropyl)-1,1,3,3-tetramethyldisiloxane, and these components were then dissolved by adding 284 g of N-methyl-2-pyrrolidone (hereafter referred to as NMP), thus obtaining a solution.

Next, 21.1 g of trimellitic anhydride chloride (hereafter referred to as TAC) was added to the above solution while performing cooling to ensure that the temperature did not exceed 20°C. After stirring for 2 hours at room temperature, 12.1 g of triethylamine (hereafter referred to as TEA) was added, and the reaction was then allowed to proceed for at least 12 hours at room temperature, thus obtaining a polyamic acid solution.

The obtained polyamic acid solution was then subjected to dehydration condensation at 180°C over a period of 8 hours, thus producing a polyamideimide resin solution. This polyamideimide resin solution was poured into water, and the resulting precipitate was separated, crushed, and dried to obtain a powdered polyamideimide resin (PAI-1). The thus obtained polyamideimide resin powder (PAI-1) was soluble in a polar solvent (NMP) at room temperature (25°C).

Measurement of the weight average molecular weight (Mw) of the obtained polyamideimide resin (PAI-1) using gel permeation chromatography (hereafter referred to as GPC) referenced against standard polystyrenes revealed a Mw value of 57,000 to 68,000.

Note that the GPC measurement conditions were as follows.
Feed pump: LC-20AD manufactured by Shimadzu Corporation UV-Vis detector: SPD-20A manufactured by Shimadzu Corporation, UV 270 nm
Eluent: tetrahydrofuran/dimethylformamide = 1/1 (volume ratio) + 0.06 M phosphoric acid + 0.06 M lithium bromide
Column: Gel-pack GL-S300MDT-5 × 2, manufactured by Hitachi High-Technologies Corporation
Column size: 8 mml. D × 300 mm
Sample concentration: 5 mg/1 mL
Flow rate: 1 mL/min Column temperature: 40°C
Molecular weight standards: standard polystyrenes

### (Synthesis Example 2)

With the exception of changing the 9,9-bis(4-aminophenyl)fluorene to 15.7 g and the 4,4'-diaminodiphenylmethane to 8.9 g in the preparation of the polyamideimide resin (PAI-1) described in Synthesis Example 1, a powdered polyamideimide resin (PAI-2) was obtained according to exactly the same method as in Synthesis Example 1.

The polyamideimide resin powder (PAI-2) was soluble in a polar solvent (NMP) at room temperature (25°C). Measurement of the weight average molecular weight (Mw) of the obtained polyamideimide resin (PAI-2) referenced against standard polystyrenes revealed a Mw value of 72,000. The Mw value was measured in the same manner as in the method described in Synthesis Example 1.

### (Synthesis Example 3)

With the exception of changing the 9,9-bis(4-aminophenyl)fluorene to 6.3 g and the 4,4'-diaminodiphenylmethane to 14.3 g in the preparation of the polyamideimide resin (PAI-1) described in Synthesis Example 1, a powdered polyamideimide resin (PAI-3) was obtained according to exactly the same method as in Synthesis Example 1.

The polyamideimide resin powder (PAI-3) was soluble in a polar solvent (NMP) at room temperature (25°C). Measurement of the weight average molecular weight (Mw) of the obtained polyamideimide resin (PAI-3) referenced against standard polystyrenes revealed a Mw value of 100,000. The Mw value was measured in the same manner as in the method described in Synthesis Example 1.

### (Synthesis Example 4)

A 1-liter four-neck flask fitted with a thermometer, a stirrer, a nitrogen inlet tube, and a condenser fitted with an oil-water separator was charged, under a stream of nitrogen, with 15.7 g of 9,9-bis(4-amino-3-methylphenyl)fluorene, 7.1 g of 1,5-diaminonaphthalene, and 2.5 g of 1,3-bis(3-aminopropyl)-1,1,3,3-tetramethyldisiloxane, and these components were then dissolved by adding 250 g of NMP, thus obtaining a solution.

Next, 21.1 g of TAC was added to the above solution while performing cooling to ensure that the temperature did not exceed 20°C. After stirring for 2 hours at room temperature, 12.1 g of TEA was added, and the reaction was then allowed to proceed for at least 12 hours at room temperature, thus producing a polyamic acid solution.

The obtained polyamic acid solution was then subjected to dehydration condensation at 180°C over a period of 8 hours, thus producing a polyamideimide resin solution. This polyamideimide resin solution was poured into water, and the resulting precipitate was separated, crushed, and dried to obtain a powdered polyamideimide resin (PAI-5). The polyamideimide resin powder (PAI-5) was soluble in a polar solvent (NMP) at room temperature (25°C).

Measurement of the weight average molecular weight (Mw) of the obtained polyamideimide resin (PAI-5) using GPC referenced against standard polystyrenes revealed a Mw value of 65,000. The Mw value was measured in the same manner as in the method described in Synthesis Example 1.

### (Synthesis Example 5)

A 1-liter four-neck flask fitted with a thermometer, a stirrer, a nitrogen inlet tube, and a condenser fitted with an oil-water separator was charged, under a stream of nitrogen, with 15.7 g of 9,9-bis(4-amino-3-methylphenyl)fluorene, 4.9 g of 1,4-phenylenediamine, and 2.5 g of 1,3-bis(3-aminopropyl)-1,1,3,3-tetramethyldisiloxane, and these components were then dissolved by adding 238 g of NMP, thus obtaining a solution.

Next, 21.1 g of TAC was added to the above solution while performing cooling to ensure that the temperature did not exceed 20°C. After stirring for 2 hours at room temperature, 12.1 g of TEA was added, and the reaction was then allowed to proceed for at least 12 hours at room temperature, thus producing a polyamic acid solution.

The obtained polyamic acid solution was then subjected to dehydration condensation at 180°C over a period of 8 hours, thus producing a polyamideimide resin solution. This polyamideimide resin solution was poured into water, and the resulting precipitate was separated, crushed, and dried to obtain a powdered polyamideimide resin (PAI-5). The polyamideimide resin powder (PAI-5) was soluble in a polar solvent (NMP) at room temperature (25°C).

Measurement of the weight average molecular weight (Mw) of the obtained polyamideimide resin (PAI-5) using GPC referenced against standard polystyrenes revealed a Mw value of 42,000. The Mw value was measured in the same manner as in the method described in Synthesis Example 1.

### (Synthesis Example 6)

A 1-liter four-neck flask fitted with a thermometer, a stirrer, a nitrogen inlet tube and a condenser fitted with an oil-water separator was charged, under a stream of nitrogen, with 102.4 g of 2,2-bis[4-(4-aminophenoxy)phenyl]propane and 6.9 g of 1,3-bis(3-aminopropyl)-1,1,3,3-tetramethyldisiloxane, and these components were then dissolved by adding 700 g of NMP, thus obtaining a solution.

Next, 59.0 g of TAC was added to the above solution while performing cooling to ensure that the temperature of the reaction solution did not exceed 20°C. After stirring for 1 hour at room temperature, 34.0 g of TEA was added while performing cooling to ensure that the temperature of the reaction solution did not exceed 20°C, and the reaction was then allowed to proceed for 3 hours at room temperature, thus producing a polyamic acid solution.

The obtained polyamic acid solution was then subjected to dehydration condensation at 190°C over a period of 6 hours, thus producing a polyamideimide resin solution.

This polyamideimide resin varnish was poured into water, and the resulting precipitate was separated, crushed, and dried to obtain a powdered polyamideimide resin (PAI-6). Measurement of the weight average molecular weight (Mw) of the obtained polyamideimide resin (PAI-6) using gel permeation chromatography (GPC) referenced against standard polystyrenes revealed a Mw value of 75,000. The Mw value was measured in the same manner as in the method described in Synthesis Example 1.

### <2> Preparation of Polyamideimide Resin Compositions

In the examples and comparative examples described below, the polyamideimide resin powders (PAI-1) to (PAI-6) produced in the above Synthesis Examples 1 to 6 were each used to prepare a polyamideimide resin composition (a primer varnish for a semiconductor device).

### (Example 1)

A 0.5-liter four-neck flask was charged, under a stream of nitrogen, with 12 g of the polyamideimide resin powder (PAI-1) obtained in Synthesis Example 1, 60.9 g of N-methyl-2-pyrrolidone, 26.1 g of butyl cellosolve acetate, and 1.2 g of a silane-based coupling agent (product name: KBM-402 (3-glycidoxypropylmethyldimethoxysilane) manufactured by Shin-Etsu Chemical Co., Ltd.), and the resulting mixture was stirred for 12 hours, thus obtaining a yellow reaction mixture. The thus obtained yellow reaction mixture was placed in a filtration device KST-47 (manufactured by Advantec Co., Ltd.), and a pressurized filtration was conducted at a pressure of 0.3 MPa, thus obtaining a semiconductor device primer varnish (P-1).

### (Example 2)

With the exception of replacing the polyamideimide resin powder (PAI-1) used in Example 1 with the powder (PAI-2) obtained in Synthesis Example 2, a semiconductor device primer varnish (P-2) was prepared in exactly the same manner as Example 1.

### (Example 3)

With the exception of replacing the polyamideimide resin powder (PAI-1) used in Example 1 with the powder (PAI-3) obtained in Synthesis Example 3, a semiconductor device primer varnish (P-3) was prepared in exactly the same manner as Example 1.

### (Example 4)

With the exception of replacing the polyamideimide resin powder (PAI-1) used in Example 1 with the powder (PAI-4) obtained in Synthesis Example 4, a semiconductor device primer varnish (P-4) was prepared in exactly the same manner as Example 1.

### (Example 5)

With the exception of replacing the polyamideimide resin powder (PAI-1) used in Example 1 with the powder (PAI-5) obtained in Synthesis Example 5, a semiconductor device primer varnish (P-5) was prepared in exactly the same manner as Example 1.

### (Comparative Example 1)

With the exception of replacing the polyamideimide resin powder (PAI-1) used in Example 1 with the powder (PAI-6) obtained in Synthesis Example 6, and also replacing the solvent with 35g of N-methyl-2-pyrrolidone and 52 g of butyl cellosolve acetate, a semiconductor device primer varnish (P-6) was prepared in exactly the same manner as Example 1.

### <3> Evaluations of Polyamideimide Resin Compositions (Primer Varnishes for Semiconductor Devices)

Various characteristics were evaluated according to the following.

### [Elastic Modulus]

Each of the semiconductor device primer varnishes (P-1) to (P-6) obtained in Examples 1 to 5 and Comparative Example 1 was applied to a substrate using a bar coater and then dried by heating to obtain a dried film with a thickness of 10 µm. The heated drying used to form the dried film involved heating at 50°C for 10 minutes and then drying at 260°C for 1 hour.

Using the dried film obtained in this manner as a measurement sample, measurement was conducted in the following manner.

The measurement sample was placed in a dynamic viscoelasticity measurement device (Rheogel-E4000) manufactured by UBM Co., Ltd., and the elastic modulus of the polyamideimide resin was measured. In the measurement, the measured value obtained at a chuck separation of 20 mm, a temperature of 35°C, and a measurement frequency of 10 MHz was taken as the elastic modulus. The measured values are shown in Table 1.

### (Glass Transition Temperature)

Each of the semiconductor device primer varnishes (P-1) to (P-6) obtained in Examples 1 to 5 and Comparative Example 1 was applied to a substrate using a bar coater and then dried by heating to obtain a dried film with a thickness of 10 µm. The heated drying used to form the dried film involved heating at 50°C for 10 minutes and then drying at 260°C for 1 hour.

Using the dried film obtained in this manner as a measurement sample, measurement was conducted in the following manner. The measurement was conducted using a thermomechanical analyzer (TMA, "SS7100" manufactured by Hitachi High-Tech Science Corporation) and under conditions of a chuck separation of 10 mm, a load of 10 g, and a rate of temperature increase of 10°C/min. The inflection point from α1 to α2, of the coefficient of linear expansion obtained by TMA measurement, was taken as the glass transition temperature.

### (Coefficient of Linear Expansion)

Each of the semiconductor device primer varnishes (P-1) to (P-6) obtained in Examples 1 to 5 and Comparative Example 1 was applied to a substrate using a bar coater and then dried by heating to obtain a dried film with a thickness of 10 µm. In order to form the dried film, heating at 50°C for 10 minutes and then drying at 260°C for 1 hour was conducted.

Measurement of the coefficient of linear expansion (CTE) was carried out using the dried film obtained in this manner as a measurement sample. The measurement was conducted using a thermomechanical analyzer (TMA, "SS7100" manufactured by Hitachi High-Tech Science Corporation) and under conditions of a chuck separation of 10 mm, a load of 10 g, and a rate of temperature increase of 10°C/min. The value calculated from the slope of a straight line joining the displacements at 70°C and 140°C was taken as the CTE value.

### (Adhesion (Shear Strength))

For each of the semiconductor device primer varnishes (P-1) to (P-6) obtained in Examples 1 to 5 and Comparative Example 1, the adhesion was evaluated using a 4000-series shear strength measurement device manufactured by ARCTEC, Inc.

Specifically, first, the primer varnish was applied onto a Ni substrate using a spray coater (model number: SV91) manufactured by SAN-EI TECH Ltd., and the varnish was then dried by heating to obtain a dried film. The thickness of the dried film was 10 µm.

Next, a resin sealing layer of ø5 mm was molded on top of the dried film to obtain a measurement sample. An epoxy-based sealing resin (CEL-420HFC) manufactured by Showa Denko Materials Co., Ltd. was used as the sealing material.

The obtained measurement sample was set on the heat stage of a 4000-series shear strength measurement device manufactured by ARCTEC, Inc., and the shear strength was measured. Measurement was conducted at a temperature of 260°C under conditions of a probe speed of 3 mm/min. The results are shown in Table 1.

Based on the measurement results for shear strength at 260°C, the adhesion in a high-temperature region was evaluated according to the criteria shown below. The evaluation results are shown in Table 1.

### <Criteria for Adhesion in High-Temperature Region>

A: shear strength at 260°C of 18.0 MPa or greater
B: shear strength at 260°C of at least 11 MPa but less than 18.0 MPa
C: shear strength at 260°C of less than 11 MPa

### (Reliability Evaluation (Moisture Absorption Reflow Test))

Each of the semiconductor device primer varnishes (P-1) to (P-6) obtained in Examples 1 to 5 and Comparative Example 1 was subjected to a moisture absorption reflow test.

Specifically, first, a package was assembled having a Si chip mounted on a Cu lead frame, and the primer varnish was then applied using a spray coater (model number: SV91) manufactured by SAN-EI TECH Ltd. and dried to obtain a dried film. The drying was conducted under conditions including a temperature of 260°C and a drying time of 1 hour.

Next, a resin sealing layer was molded on top of the dried film using a "CEL-8240", product name, manufactured by Showa Denko Materials Co., Ltd. as the sealing material to obtain an evaluation sample.

Next, the obtained evaluation sample was used to conduct a moisture absorption reflow test under the following conditions.
Moisture absorption conditions: JEDEC MSL 1 (85°C/85% RH × 168 hours)
Reflow conditions: 260°C/10 seconds × 3 repetitions

Next, the semiconductor device was inspected before and after the reliability test (moisture absorption reflow test) with a high-precision ultrasonic microscope (C-SAM) to ascertain whether or not detachment had occurred between the resin sealing layer, the resin dried film (primer layer), and the lead frame. The results are shown in Table 1.

The reliability test evaluation results shown in Table 1 indicate the number of samples in which detachment was confirmed (the numerator) relative to the total number of samples evaluated (the denominator). The inspection conditions were as follows.

Apparatus: high-precision ultrasonic microscope (C-SAM) D9600 manufactured by Sonoscan Corporation, oscillation frequency: 30 MHz
Conditions: room temperature (25°C ± 5°C), pure water used

The results of the characteristics evaluations in Examples 1 to 5 and Comparative Example 1 are summarized in Table 1.

**[Table 1]**

| | Structure of PAI Resin | | | | | | Characteristics | | | | | | Reliability Test | |
|---|---|---|---|---|---|---|---|---|---|---|---|---|---|---|
| | Diamine-Derived Structural Unit | | | | | | Mw | Tg (°C) | Elastic Modulus (GPa) | CTE (ppm/°C) | Adhesive Strength | | Before Test | After Test |
| | Ia | IIa | IIb | IIc | IIIa | I'-II' | | | | | (MPa) | Eval. | | |
| Example 1 | 72% | 18% | - | - | 10% | | 57,000 -68,000 | 329 | 3.4 | 62 | 18.0 | A | 0/16 | 0/16 |
| Example 2 | 45% | 45% | - | - | 10% | | 72,000 | 294 | 3.7 | 62 | 19.5 | A | 0/16 | 15/16 |
| Example 3 | 18% | 72% | - | - | 10% | | 100,000 | 276 | 3.9 | 55 | 17.0 | B | 0/16 | 14/16 |
| Example 4 | 45% | - | 45% | - | 10% | | 65,000 | 327 | 3.4 | 47 | 17.4 | B | 0/16 | 7/16 |
| Example 5 | 45% | - | - | 45% | 10% | | 42,000 | 328 | 3.4 | 56 | 17.4 | B | 0/16 | 4/16 |
| Comparative Example 1 | - | - | - | - | 10% | 90% | 75,000 | 220 | 2.8 | 65 | 10.0 | C | 0/16 | 16/16 |

In Table 1, the diamine-derived structural unit I'-II' is a structural unit derived from 2,2-bis[4-(4-aminophenoxy)phenyl]propane.

As above, with the resin compositions of the present invention (Examples 1 to 5), excellent adhesion was obtained even in high-temperature conditions of 260°C. In contrast, with the resin composition of Comparative Example 1, the Tg was lower than in Examples 1 to 5, and the results of the adhesion test under high-temperature conditions of 260°C were markedly inferior. The resin composition of Comparative Example 1 uses a polyamideimide resin that does not have a cardo structure fluorene skeleton.

Furthermore, the results of the reliability test conducted by moisture absorption reflow testing of Examples 1 to 3 shows that the Tg can be easily increased by adjusting the ratio of structural unit (Ia) and structural unit (IIa). In addition, as seen in Examples 1, 4 and 5, when the Tg exceeds 300°C, it can be seen that favorable results can be obtained in the moisture absorption reflow test and reliability can be easily increased, together with excellent adhesion under high-temperature conditions.

Based on the above, it is evident that it is possible to provide a resin and a resin composition exhibiting excellent adhesion in a high-temperature region and being capable of improving the reliability of semiconductor devices, by means of a polyamideimide resin having the combination of a specific structural unit and a structural unit having a cardo structure fluorene skeleton, according to the present invention.

### DESCRIPTION OF THE REFERENCE SIGNS

1: Lead frame, Cu substrate
1a: Die pad
1b: Lead
2: Semiconductor element
3: Primer layer (resin composition film)
4: Wire
5: Resin sealing layer

## Claims

1. A polyamideimide resin containing a structural unit (Ia) represented by a formula below, and at least one selected from the group consisting of structural units (IIa), (IIb), and (IIc) represented by a formula below. 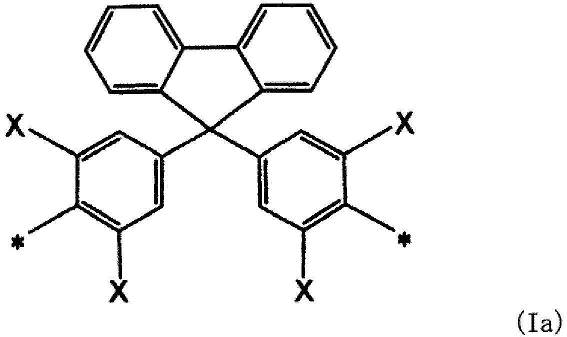 [In formula (Ia), each X independently represents a hydrogen atom or a substituent selected from the group consisting of a halogen atom, an alkyl group of 1 to 9 carbon atoms, an alkoxy group of 1 to 9 carbon atoms, and a hydroxyalkyl group.] 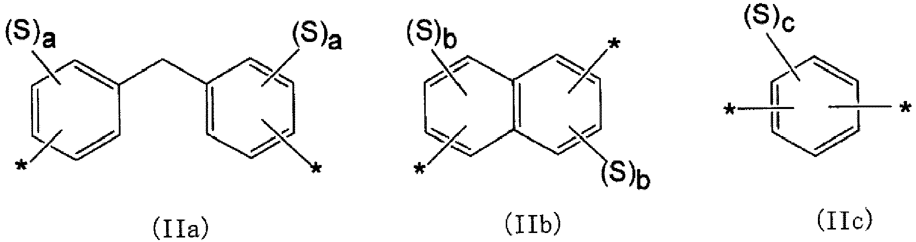 [In formulas (IIa), (IIb), and (IIc), each S independently represents an alkyl group of 1 to 3 carbon atoms, a represents an integer of 0 to 4, b represents an integer of 0 to 3, and c represents an integer of 0 to 4.]

2. The polyamideimide resin according to Claim 1, further containing a structural unit (IIIa) represented by a formula below. 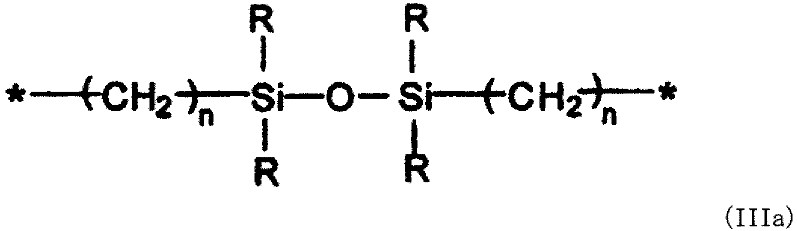 [In formula (IIIa), each R independently represents a hydrogen atom or a substituent selected from the group consisting of an alkyl group of 1 to 9 carbon atoms, an alkoxy group of 1 to 9 carbon atoms, and a halogen atom, and n represents an integer of 1 to 6.]

3. The polyamideimide resin according to Claim 1 or 2, wherein a coefficient of linear expansion is 40 to 70 ppm/°C.

4. The polyamideimide resin according to any one of Claims 1 to 3, wherein a proportion of the structural unit (Ia) is 20 mol% or more based on a total amount of the structural unit (Ia) and at least one selected from the group consisting of the structural units (IIa), (IIb), and (IIc).

5. The polyamideimide resin according to any one of Claims 1 to 4, wherein a glass transition temperature is 250°C or higher.

6. The polyamideimide resin according to any one of Claims 1 to 5, wherein a glass transition temperature is 300°C or higher.

7. A polyamideimide resin composition comprising the polyamideimide resin according to any one of Claims 1 to 6, and a solvent.

8. A semiconductor device comprising a substrate, and a film formed using the polyamideimide resin composition according to Claim 7.

9. The semiconductor device according to Claim 8, further comprising a resin sealing layer.
